# FASCICULE DE BREVET EUROPEEN

(11) **EP 2 138 452 B1**
(45) Date de publication et mention de la délivrance du brevet: **27.02.2013**
(21) Numéro de dépôt: 09290472.1
(22) Date de dépôt: 22.06.2009
(51) Int. Cl.: B81C 1/00

(54) **Procédé de fabrication d'un dispositif microélectromécanique comprenant au moins un élément actif**
Verfahren zur Herstellung einer mikroelektromechanischen Vorrichtung, die mindestens ein aktives Element umfasst
Method for manufacturing a microelectromechanical device comprising at least one active element.

(30) Priorité: 23.06.2008 FR 0803497
(43) Date de publication de la demande: 30.12.2009
(73) Titulaire: Commissariat à l'Énergie Atomique et aux Énergies Alternatives, 75015 Paris (FR)
(72) Inventeur: Perruchot, François, 38000 Grenoble (FR); Diem, Bernard, 38130 Echirolles (FR); Larrey, Vincent, 38140 La Murette (FR); Clavelier, Laurent, 38000 Grenoble (FR); Defay, Emmanuel, 38340 Voreppe (FR)
(74) Mandataire: Rataboul, Xavier

(56) Documents cités:
- EP-A- 0 554 795
- FR-A- 2 906 078

## Description

La présente invention a pour objet un procédé de fabrication d'un dispositif électromécanique comprenant au moins un élément actif.

Les technologies dites de surface (par opposition aux technologies de volume) permettent de réduire la taille des structures électromécaniques (micro-électromécaniques MEMS/nanoélectromécaniques NEMS) réalisées sur silicium. Ces technologies reposent sur l'utilisation d'un empilement d'au moins trois couches : une couche mécanique (dont l'épaisseur est typiquement de 0,1 à 100 µm), une couche sacrificielle (dont l'épaisseur est typiquement de 0,1 à quelques µm) et un support (dont l'épaisseur est typiquement de 10 à 1000 µm), la gravure chimique sélective de la couche sacrificielle permettant de réaliser dans la couche mécanique des structures fonctionnelles localement indépendantes du support.

Les zones non gravées de la couche sacrificielle permettent de réaliser des zones dites d'ancrage par lesquelles la structure mécanique est reliée au support.

Un procédé donné est en particulier caractérisé par le choix du couple couche mécanique - couche sacrificielle et de la méthode permettant de les associer au support.

Le choix d'un procédé se fait suivant des critères différents suivant le type de composant réalisé mais pour disposer d'un procédé flexible apte à s'adapter à une large gamme de demandes, mais par exemple pour la réalisation d'une couche mécanique sur une couche sacrificielle, les principaux critères retenus sont
- la qualité de la couche mécanique, en premier lieu la stabilité de ses propriétés mécaniques mais aussi la précision sur son contrôle dimensionnel, en particulier la précision sur son épaisseur,
- et/ou la possibilité de contrôler les dimensions latérales des zones d'ancrage par insertion dans la couche sacrificielle de zones non attaquées par la gravure chimique pour ne pas dépendre d'un contrôle par temps de gravure sensible au design,
- et/ou la possibilité de disposer d'au moins un ou plusieurs niveaux d'interconnexions électriques au dessus ou/et en dessous de la couche mécanique, pouvant servir d'électrodes si nécessaire,

La famille de procédés la plus utilisée repose sur le couple silicium (couche mécanique) sur silice (couche sacrificielle) associé à une gravure sélective de la silice par HF (liquide ou en phase vapeur). Cette famille fait partie des procédés MEMS SOI (pour Silicon on Insulator, c'est-à-dire Si sur isolant).

Un tel procédé est connu par exemple de FR-A-906 078.

Les procédés MEMS SOI les plus simples réalisent les deux couches SiO₂/Si par dépôts successifs des matériaux : SiO₂ thermique ou par dépôt PECVD , LPCVD ou ALCVD si très fin, respectivement dépôt en phase vapeur avec plasma, dépôt en phase vapeur basse pression, ou dépôt en phase vapeur à couche atomique) ; Si par dépôt chimique en phase vapeur de type PE, LP ou RP (respectivement plasma réactif, basse pression, ou plasma hydrogène) , ou dépôt de couche atomique ALD si très fin sur un support en silicium tel qu'un substrat en silicium massif.

Ces procédés sont avantageux car,
- le contrôle de l'épaisseur de la couche mécanique est obtenu par le temps de dépôt de la couche de silicium,
- les éventuelles zones d'ancrage sont très bien contrôlées puisque qu'il est possible d'utiliser directement la couche mécanique en gravant localement la couche d'oxyde avant le dépôt de silicium,
- il est possible de réaliser différents niveaux d'interconnexions.

Cependant, le silicium composant la couche mécanique déposé sur de l'oxyde est du silicium polycristallin, ce qui rend plus difficile le contrôle de ses qualités mécaniques (contrôle des contraintes, stabilité, ...) et limite l'épaisseur pouvant être obtenue.

Des améliorations connues de ces procédés permettent d'utiliser comme couche mécanique du silicium monocristallin dont les propriétés mécaniques sont considérées comme supérieures avec une gamme d'épaisseurs accessibles plus importante.

Il est possible de citer trois grandes familles de procédés connus pour la réalisation d'un MEMS ayant une couche mécanique en silicium monocristallin par la technologie MEMS SOI, familles qui se distinguent par la méthode retenue pour réaliser le substrat comportant l'empilement complet :
1 - Le substrat de départ est un substrat SOI fin de type microélectronique d'épaisseur contrôlée (typiquement de l'ordre de 100 nm) par exemple réalisé par clivage selon la technologie Smart Cut^{™} (Marque déposée). La couche en SiO₂ qui sert d'isolant par rapport au substrat est utilisée comme couche sacrificielle et la couche de silicium fin sert de base à une épitaxie de silicium ce qui permet de conserver son caractère monocristallin.
   Il est par ailleurs connu de réaliser des niveaux d'interconnexions au dessus de la couche mécanique et des ancrages en SiN ou Si polycristallin comme dans l'article "Polysilicon Packaging and a new anchoring technology for thick SOI-MEMS - Dynamic response model and application to over-damped inertial sensors" de B. DIEM et collaborateurs paru dans 13th Int'l Conférence on Solid State Sensors Actuators and Microsensors - Séoul 5 June 2005, p. 527-530".
2 - Le substrat de départ est un substrat de silicium comportant la couche d'oxyde. La couche mécanique est réalisée par collage d'un second substrat de silicium épais qui est ensuite aminci par rectification et polissage (voir par exemple la Demande PCT/WO2006/03531). Avec ce procédé, la couche sacrificielle est utilisée comme couche d'adhésion ; la qualité de collage est critique car il doit garantir que la gravure chimique sera homogène. L'implémentation de zones d'ancrage dans la couche sacrificielle avant collage est possible mais elle demande de maîtriser le collage de substrats hétérogènes.
3 - Le substrat de départ est un substrat de silicium épais sur lequel sont déposées la couche sacrificielle d'oxyde puis une multicouche de fonctionnalisation comprenant du SiN associé à du Si polycristallin et enfin une couche finale de d'adhésion en Si polycristallin. Cet empilement initial est collé sur un second substrat de silicium servant de support. Le substrat épais de base est ensuite aminci par une rectification suivie d'un polissage pour réaliser la couche mécanique. On se réfère par exemple à. l'article de T. YAMAMOTO et Collaborateurs (Capacitive Accelerometer with High Aspect single crystalline Silicon Microstructure Using the SOI Structure with Polysilicon-Based Interconnect technique publié dans MEMS 2000, the thirteenth annual international conference, 23-27 janvier 2000, Miyazaki, Japan, pages 514-519). Le procédé proposé permet de réaliser des zones d'ancrage en Si polycristallin, des couches d'interconnexion et des électrodes enterrées et la couche d'adhésion est distincte de la couche sacrificielle, donc la qualité du collage est moins critique car elle n'a que des fonctions mécaniques.

Des procédés cités, seul le procédé 1 permet de contrôler de manière précise l'épaisseur de la couche mécanique. En effet, l'amincissement du substrat de base pour obtenir la couche mécanique tel que proposé pour 2 et 3 est réalisé au mieux à ce jour avec une précision de l'ordre de ± 0.5 µm (dans le meilleur des cas sur du 200mm) et dépend des fluctuations d'épaisseur des substrats de silicium utilisés. Lorsque l'épaisseur des structures est de l'ordre de quelques µm, cette précision n'est pas suffisante, en particulier lorsque l'épaisseur est utilisée pour dimensionner une élasticité, comme c'est le cas par exemple pour des capteurs de force ; en général on souhaite une variation de sensibilité inférieure à 10% qui varie comme le cube de l'épaisseur.

Pour le procédé 1, l'épaisseur est déterminée par le temps de l'épitaxie sur la couche fine de Si donc avec une bien meilleure précision. Ce principe a été proposé pour améliorer le procédé 2 en utilisant comme second substrat un substrat SOI épitaxié.

Mais dans tous les cas, les procédés 1 modifié ou 2 ne sont pas des procédés aussi flexibles que le procédé 3 qui permet à la fois de réaliser des arrêts de gravure et des électrodes enterrées.

Les procédés de transfert de couche connus pour réaliser les substrats sont bien adaptés pour contrôler l'épaisseur des couches mais ils sont utilisés pour réaliser une structure composée d'une couche sur isolant, typiquement sur oxyde. L'opération de collage s'effectue donc au niveau de cette couche qui pour les procédés de fabrications de structures électromécaniques de type MEMS est utilisée comme couche sacrificielle. Comme souligné précédemment le collage est dans ce cas critique car de sa qualité dépend l'homogénéité et la possibilité de contrôle de la vitesse de la gravure.

Il n'existe pas actuellement de procédé bien adapté à la réalisation de structures électromécaniques de type MEMS et permettant de contrôler l'épaisseur de la couche active de manière précise.

La présente invention a pour objet un procédé flexible permettant de réaliser des MEMS/NEMS en silicium monocristallin à partir d'une technologie par exemple à base de SOI dont on peut contrôler l'épaisseur y compris pour les faibles épaisseurs, tout en maintenant une température de fabrication compatible avec les matériaux présents.

L'invention permet notamment un développement avantageux pour un empilement piezoélectrique utilisé pour des structures de type BAW (bulk acoustic wave ou à ondes acoustique de volume), pour lequel le critère de sélection de la filière peut être relié aux qualités physiques des matériaux utilisables. Il est à ce titre souhaitable de pouvoir utiliser certains matériaux en couche mince sous forme monocristalline pour obtenir, y compris à faible épaisseur, des propriétés physiques proches des propriétés du monocristal massique ou au moins supérieures à celles obtenues avec des films amorphes ou polycristallin réalisés par dépôt ou sol-gel. C'est le cas par exemple du PZT qui peut être réalisé par épitaxie à partir d'une couche de transition sur du silicium monocristallin (voir l'article Epitaxial growth of Pb(Zr0.2Ti0.8)O3 on Si and its nanoscale piezoelectric properties, A. Lin et collaborateurs, Applied Physics Letters, volume 78-14 du 2 avril 2001). C'est également le cas du PMNT.

Dans ce cas, le contrôle de l'épaisseur est d'autant plus important que les couches piezoélectriques sont en général minces, typiquement de 100 nm à quelques microns.

L'invention concerne ainsi un procédé de fabrication d'un dispositif électromécanique comprenant un élément actif, **caractérisé en ce qu**'il comporte :
a) la réalisation d'une première couche d'arrêt monocristalline sur une couche monocristalline d'un premier substrat,
b) l'épitaxie sur ladite première couche d'arrêt, d'une couche mécanique monocristalline en au moins un matériau différent de celui de la couche d'arrêt,
c) la réalisation sur ladite couche active, d'une couche sacrificielle en un matériau apte à être gravé sélectivement par rapport à ladite couche active,
d) la réalisation d'une couche d'adhésion sur la couche sacrificielle,
e) le collage d'un deuxième substrat sur la couche d'adhésion
f) l'élimination du premier substrat et de la couche d'arrêt pour mettre à nu la surface de la couche mécanique opposée à la couche sacrificielle, l'élément actif étant réalisé par au moins une partie de la couche mécanique.

Le procédé peut comporter avant le dépôt de la couche d'adhésion, le dépôt d'une deuxième couche d'arrêt.

Le procédé peut alors être **caractérisé en ce que**, après l'étape c) il met en oeuvre :
c₁) la réalisation d'au moins une tranchée dans la couche sacrificielle,
c₂) le remplissage de la ou des tranchées pour former au moins un pilier, ce remplissage étant réalisé au moins partiellement en un matériau différent de celui de la couche sacrificielle.

Le procédé peut alors être **caractérisé en ce que** c₂ comporte :
c₂₁) pour au moins une tranchée, remplissage partiel par un premier matériau différent de celui de la couche sacrificielle et
c₂₂) achèvement du remplissage avec un deuxième matériau isolant différent du premier matériau.

Le premier matériau peut être choisi isolant ou conducteur.

Le procédé peut être **caractérisé en ce que**, pour au moins une tranchée, il présente un remplissage partiel par un premier matériau isolant différent du matériau de la couche sacrificielle et de la couche mécanique, puis pour les autres tranchées par un matériau conducteur, le remplissage de toutes les tranchées étant terminé par un deuxième matériau isolant.

Le procédé peut être **caractérisé en ce que** le remplissage partiel d'au moins une tranchée par un matériau conducteur comporte la réalisation d'au moins une région recouvrant la surface de la couche sacrificielle, pour former au moins un contact électrique entre un ou plusieurs piliers conducteurs.

Le remplissage peut être réalisé par la couche d'adhésion.

Le procédé peut être **caractérisé en ce que** le deuxième substrat comporte au moins un circuit électronique, notamment CMOS, et en ce que la couche d'adhésion présente des plots localisés aptes à réaliser des contacts électriques entre le circuit électronique et lesdites régions de prise de contact.

Le procédé peut être **caractérisé en ce qu**'il comporte avant b, un dopage d'au moins une région localisée de la couche active pour permettre la réalisation d'un capteur piézorésistif.

Le matériau de la couche d'arrêt peut être choisi notamment parmi du SiGe, le Si poreux ou le Si dopé.

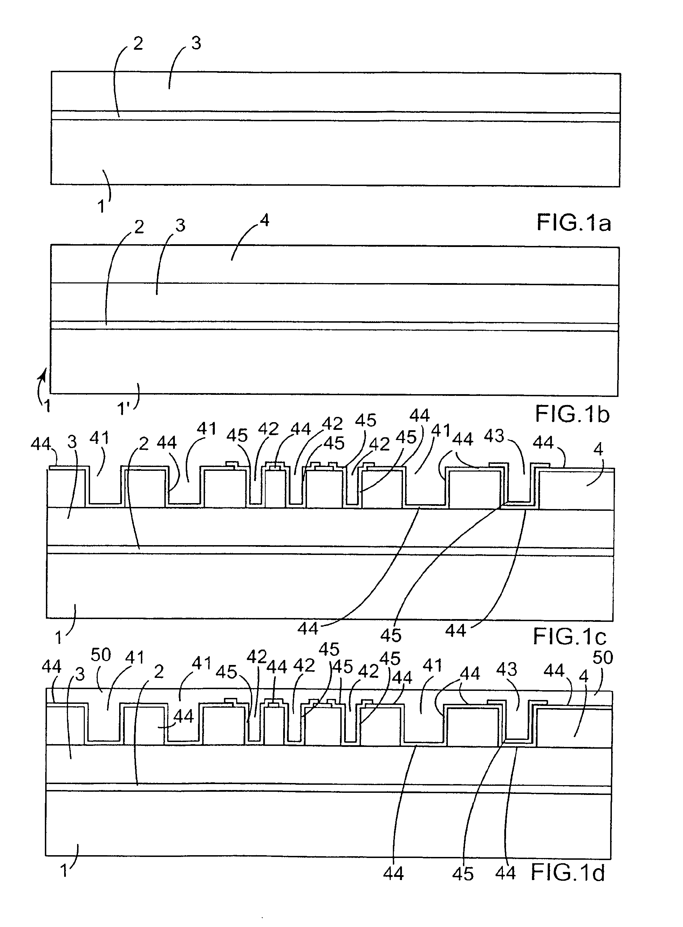

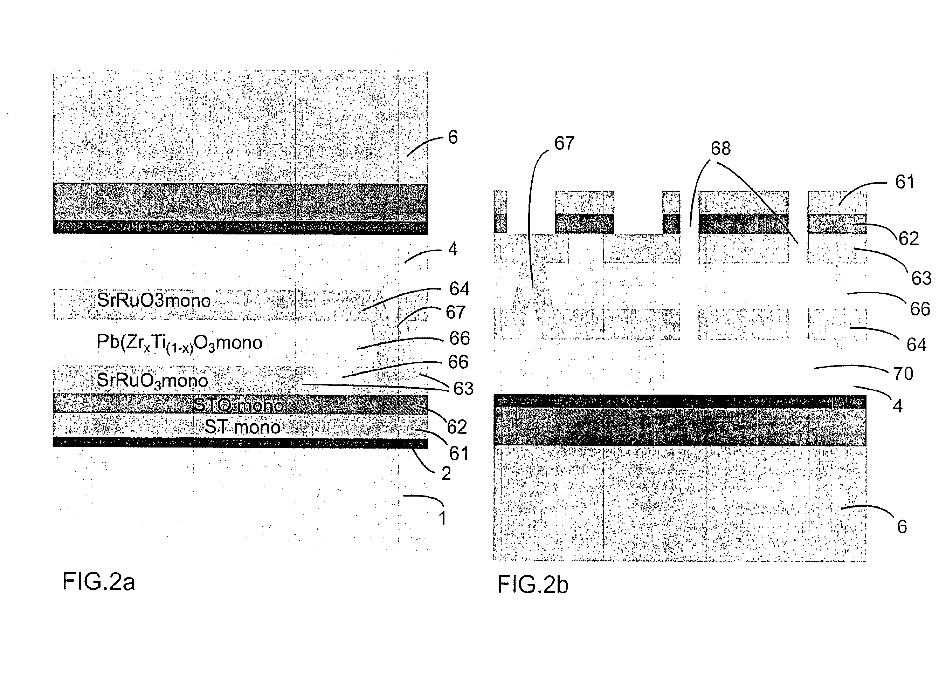

D'autres caractéristiques et avantages de l'invention apparaîtront mieux à la lecture de la description qui va suivre, donnée à titre d'exemple non limitatif, en liaison avec les dessins dans lesquels les figures 1a à 1f et 2a à 2b illustrent deux modes de réalisation préférés de l'invention.

Le premier mode de réalisation (figures 1a à 1f) concerne la réalisation d'une structure mécanique en silicium monocristallin.

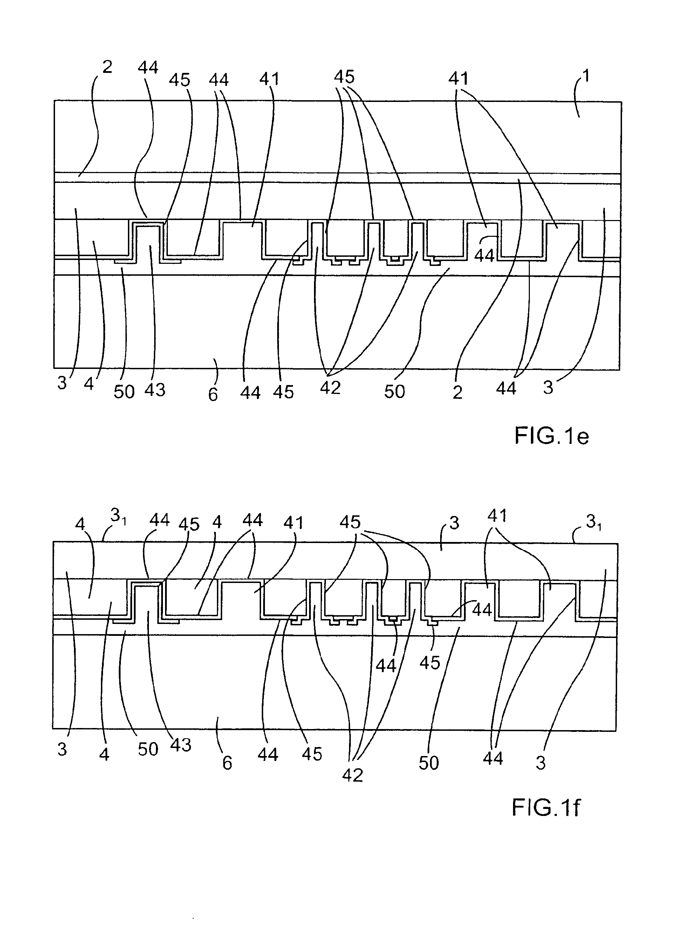

La figure 1 a montre un substrat silicium monocristallin 1 sur lequel a été réalisée une première couche d'arrêt 2. Cette couche d'arrêt 2 est en matériau monocristallin compatible avec l'épitaxie de la couche mécanique 3.

Selon une première variante, la couche d'arrêt 2 est une couche de SiGe déposée par épitaxie dont l'épaisseur est de l'ordre de 100 nm.

Selon une deuxième variante, la couche d'arrêt est une couche en Si poreux réalisée sur le substrat de départ par un procédé connu (voir par exemple l'article « Using porous silicon as sacrificial layer » par P Steiner, J. Micromech. Microeng. 3 (1993) 3236)

La couche mécanique 3 en Si monocristallin est ensuite épitaxiée avec une épaisseur comprise entre 100 nm et 100 µm suivant les applications. Dans le cas d'une couche d'arrêt en SiGe, la teneur en Ge de la couche en SiGe est comprise par exemple entre 10 et 70% en mole de manière à minimiser les contraintes induites sur la couche mécanique.

La couche sacrificielle 4 par exemple en SiO₂ est ensuite déposée par LPCVD (dépôt chimique en phase vapeur à basse pression) ou PECVD (dépôt chimique en phase vapeur à l'aide d'un plasma) ou obtenue par oxydation du silicium (figure 1b) avec une épaisseur comprise typiquement entre 50 nm et quelques µm suivant les applications.

Optionnellement, la couche sacrificielle 4 peut ensuite être localement gravée pour réaliser des zones d'ancrage. La couche dite d'interconnexion qui revêt la couche sacrificielle 4 peut être une alternance de plages en SiN 44 (typiquement 100 nm) pour les parties isolantes, et de plages en Si polycristallin 45 pour les parties conductrices, un isolant tel que le SiO₂ pouvant être utilisé pour le remplissage des tranchées. Pour réaliser différents niveaux d'interconnexion, il est possible d'utiliser des couches multiples 44 de SiN et 45 de Si polycristallin.

La figure 1c montre trois types de tranchées.

La ou les tranchées 41 sont revêtues d'une couche isolante 44 en SiN de même que la surface 41 de la couche sacrificielle 4.

La ou les tranchées 42 sont revêtues d'une couche conductrice 45 en Si polycristallin qui vient en débord sur la surface de la couche sacrificielle 4 et éventuellement sur une extrémité de la couche isolante 44. La couche 45 peut servir à interconnecter deux ou plusieurs parties de la couche mécanique 3 en regard des tranchées 42 ou à réaliser des électrodes ou des pistes conductrices sur la couche sacrificielle.

La ou les tranchées 43 sont revêtues d'une couche isolante 44 en SiN, et d'une couche conductrice 45 en Si polycristallin, ce qui permet de réaliser un passage électrique à travers un arrêt de gravure isolant.

Les zones gravées de la couche sacrificielle permettent de réaliser dans la couche mécanique des structures fonctionnelles localement indépendantes du support.

Les zones non gravées de la couche sacrificielle permettent de réaliser des zones dites d'ancrage ou de renfort mécanique (ou « piliers »). Les couches 44 et 45 sont appelées couche de fonctionnalisation car elles permettent d'ajouter des fonctions à la couche sacrificielle : des piliers réalisés avec des arrêts de gravure, des électrodes sous la couche sacrificielle, des connexions électriques entre la couche mécanique et ces électrodes ou entre des parties de la couche mécanique non reliées.

Avec la réalisation de cette couche de fonctionnalisation, la surface de la couche sacrificielle peut ainsi être revêtue d'une couche jouant le rôle de deuxième couche d'arrêt lorsqu'elle recouvre complètement la couche sacrificielle. La deuxième couche d'arrêt permet d'isoler chimiquement la couche sacrificielle de la couche d'adhésion.

Dans l'exemple représenté, la couche de fonctionnalisation alterne donc des régions isolantes et des régions conductrices, ce qui permet de réaliser des prises de contacts et/ou des interconnexions et/ou des électrodes ainsi que la réalisation dans la couche sacrificielle d'arrêt de gravure isolant ou conducteurs.

Les tranchées 41, 42 et/ou 43 sont ensuite remplies de SiO₂.

La dernière couche déposée est la couche d'adhésion 50 qui peut être réalisée en SiO₂. Cette couche peut être la même que celle ayant servi au remplissage des cavités 41, 42, 43. Cette couche devant être parfaitement plane, un polissage est réalisé après son dépôt ou bien avant son dépôt, la couche ensuite déposée conservant la planéité.

La réalisation de zones d'ancrage n'est qu'optionnelle. Il est en effet possible de graver la couche sacrificielle à partir de puits de la couche mécanique 3 et de laisser subsister des régions choisies de I couche sacrificielle en contrôlant le temps de gravure. Cette technique convient en particulier aux systèmes MEMS dont la structure est simple et ne nécessite pas une précision particulière.

Le deuxième substrat 6 est ensuite assemblé par collage moléculaire (figure 1e).

Le deuxième substrat 6 peut comporter un ou plusieurs circuits CMOS. Dans ce cas, la couche d'adhésion 50 est une couche mixte comportant un réseau de plots Cu sur SiO₂ permettant de réaliser des contacts entre la partie CMOS et la couche de fonctionnalisation en ses régions 45 en Si polycristallin. Le deuxième substrat comporte également une couche d'adhésion identique. Pour cette variante, le collage et les étapes suivantes doivent se faire à des températures compatibles avec la technologie CMOS. Un tel collage est possible, car l'assemblage n'a qu'un rôle mécanique. La couche d'adhésion permet alors de réaliser une connexion électrique entre certaines parties du MEMS et les circuits CMOS. Il est à noter que tous les plots ne sont pas nécessairement actifs pour réaliser la connexion électrique, certains pouvant être utilisés uniquement pour obtenir une force de collage suffisante. Dans ce cas, la connexion électrique vers le circuit CMOS peut se faire à partir de contacts réalisés à la surface du système MEMS.

L'empilement est ensuite retourné pour accéder à la face arrière 31 du premier substrat 1.

Dans la première variante, à savoir avec une couche d'arrêt 2 mince de SiGe d'épaisseur typiquement 100 nm, le premier substrat est ensuite rectifié jusqu'à une épaisseur d'environ 10 µm. L'épaisseur est déterminée par la précision disponible pour cette étape de rectification et aussi de manière à ce la couche mécanique ne comporte plus de zones écrouies, créées lors de l'étape de rectification. C'est donc une fonction en particulier de la vitesse de rectification souhaitée.

L'épaisseur de Si restante du premier substrat 1 est ensuite enlevée par gravure chimique, avec arrêt sur la couche 2 en SiGe. Il existe différentes méthodes connues pour la gravure de Si avec arrêt sur SiGe. On citera les méthodes de gravure humides, par exemple solution à base de TMAH (hydroxyde de tetraméthylammonium) ou de KOH ou en gravure sèche (Japanese Journal of Applied Physics , Vol. 43, No. 6B, 2004, pp. 3964-3966 , 2004 The Japan Society of Applied Physics).

Dans la seconde variante, la couche d'arrêt 2 est une couche de Si poreux épaisse (typiquement de l'ordre de 10 µm). Dans ce cas, la rectification du substrat 1 est réalisée jusqu'à atteindre la couche d'arrêt 2.

Enfin pour les deux variantes, la première couche d'arrêt 2 est enlevée par gravure chimique avec arrêt sur le Si de la couche mécanique 3 (figure 1f), que la couche 2 soit en SiGe ou en Si poreux.

Il existe différentes procédés connus de gravure du SiGe avec arrêt sur Si. On citera des procédés de gravure HCl en température (Selective chemical vapour etching of Si1-xGex versus Si with gaseous HCl by Y Bogumilowicz, J M Hartmann, J M Fabri and T Billon in Semicond. Sci. Technol. 21 No 12 (December 2006) 1668-1674), des procédés de gravure chimique à base de solutions de type HNA (acide fluorhydrique, acide acétique, acide nitrique) et des procédés de gravure sèche (Japanese Journal of Applied Physics , Vol. 43, No. 6B, 2004, pp. 3964-3966 , 2004 The Japan Society of Applied Physics).

Pour la gravure du Si poreux avec arrêt sur Si, on pourra se référer par exemple à l'article « using porous silicon as sacrificial layer » par P Steiner déjà cité. Dans ce cas, la couche d'arrêt 2 peut être oxydée avant gravure chimique pour augmenter la sélectivité de l'arrêt sur le SiGe de la couche mécanique 3.

Le procédé se termine par la structuration de la couche mécanique 3 par gravure ionique réactive profonde DRIE et la gravure de la couche sacrificielle 4 (HF en phase vapeur par exemple).

Pour un capteur comprenant une cavité déformable (capteur de pression ou un capteur de force), , les cavités sont scellées par une couche de verre phosphosilicate PSG, ou bien de SiN ou de SiO₂ à 300°C si l'empilement comprend des circuits CMOS. Les contacts sont repris par la face supérieure en réalisant des piliers en silicium isolés localement de la couche mécanique par des tranchées.

Pour un capteur nécessitant un capotage (capteur inertiel), il est possible d'utiliser une technique connue de réalisation d'un capot en couche mince par rebouchage.

Pour la réalisation de capteurs, le procédé proposé permet d'utiliser soit une détection capacitive, soit une détection piezorésistive. Dans ce dernier cas, un dopage est réalisé dans la couche mécanique 3 de préférence avant le dépôt de la couche sacrificielle afin d'implémenter les jauges piezorésistives nécessaires.

Le deuxième mode de réalisation illustré par les figures 2a et 2b correspond à une couche active qui n'est pas du silicium monocristallin.

Il est avantageux de pouvoir utiliser certains matériaux en couche mince sous la forme d'un monocristal lorsque cela permet d'obtenir des propriétés physiques, y compris à faible épaisseur, proches des propriétés du monocristal massique ou en tout cas supérieures à celles obtenues pour le même matériau obtenu dans une phase amorphe ou polycristalline. Dans la famille des perovskytes, c'est le cas par exemple des oxydes ferroélectriques comme le PZT qui peut être réalisé par épitaxie à partir d'une couche de transition en SrTi03 sur du silicium monocristallin avec des propriétés potentiellement supérieures, à celles des films amorphes ou polycristallin réalisés par dépôt ou sol-gel (article cité précédemment de A. Lin et collaborateurs).

La première couche d'arrêt pour le contrôle de l'épaisseur comporte une couche de SiGe monocristallin 2, réalisée comme dans le premier mode de réalisation sur un substrat en silicium monocristallin 1. Une couche de transition composée d'une couche de silicium monocristallin 61 et d'une couche de perovskite STO monocristallin 62 est réalisée par épitaxie (STO correspond à SrTiO₃). L'empilement piezoélectrique correspondant à la couche mécanique 3 est composé d'électrodes 63, 64 en SrRu03 monocristallin associées à une couche piézoélectrique 66 de PZT selon un procédé connu (article cité précédemment de A. Lin et collaborateurs). Le procédé est ensuite identique à celui décrit précédemment pour réaliser la couche sacrificielle 4 avec éventuellement les arrêts de gravure, les reprises de contact et la couche d'adhésion. Les gravures locales de la première électrode 63 et de la couche de PZT 66 permettent d'utiliser le cas échéant la première couche de SrRuO3 63à la fois pour la première électrode et pour réaliser une connexion électrique 67 vers la deuxième électrode (figure 2a).

Des ouvertures sont réalisées dans la masse de la structure résonante pour libérer localement la structure piézoélectrique à partir de la gravure de la couche sacrificielle 70 réalisée telle que décrite précédemment. Les contacts sont repris sur la couche de SrRu03 en éliminant localement la couche de transition en Si et en perovskite STO par gravure (figure 2b).

Le composant ainsi obtenu est un résonateur à ondes acoustiques de surface BAW de type FBAR c'est-à-dire réalisé sur cavité.

## Revendications

1. Procédé de fabrication d'un dispositif électromécanique comprenant un élément actif, **caractérisé en ce qu'**il comporte :
a) la réalisation d'une première couche d'arrêt monocristalline (2) sur une couche monocristalline (1') d'un premier substrat (1),
b) l'épitaxie sur ladite première couche d'arrêt (2), d'une couche mécanique monocristalline (3) en au moins un matériau différent de celui de la couche d'arrêt (2),
c) la réalisation sur ladite couche active (3), d'une couche sacrificielle (4), en un matériau apte à être gravé sélectivement par rapport à ladite couche mécanique (3).
d) la réalisation d'une couche d'adhésion (50) sur la couche sacrificielle (4),
e) le collage d'un deuxième substrat (6) sur la couche d'adhésion (50),
f) l'élimination du premier substrat (1) et de la couche d'arrêt (2) pour mettre à nu la surface (3₁) de la couche mécanique (3) opposée à la couche sacrificielle (4), l'élément actif étant réalisé par au moins une partie de la couche mécanique (3).

2. Procédé selon la revendication 1, **caractérisée en ce qu'**il comporte avant le dépôt de la couche d'adhésion (50), le dépôt d'une deuxième couche d'arrêt.

3. Procédé selon l'une des revendications précédentes, **caractérisé en ce que**, après l'étape c) il met en oeuvre :
c₁) la réalisation d'au moins une tranchée (41, 42, 43) dans la couche sacrificielle (4),
c₂) le remplissage de la ou des tranchées pour former au moins un pilier, ce remplissage étant réalisé au moins partiellement en un matériau différent de celui de la couche sacrificielle (4).

4. Procédé selon la revendication 3, **caractérisé en ce que** c₂ comporte :
c₂₁) pour au moins une tranchée (41, 42), remplissage partiel par un premier matériau différent de celui de la couche sacrificielle (4) et
c₂₂) achèvement du remplissage avec un deuxième matériau isolant différent du premier matériau.

5. Procédé selon la revendication 4, **caractérisé en ce que** le premier matériau est isolant.

6. Procédé selon la revendication 4, **caractérisé en ce que** le premier matériau est conducteur.

7. Procédé selon la revendication 4, **caractérisé en ce que** pour au moins une tranchée (43), il présente un remplissage partiel par un premier matériau isolant différent du matériau de la couche sacrificielle (4) et de la couche mécanique (3), puis pour les autres tranchées par un matériau conducteur, le remplissage de toutes les tranchées étant terminé par un deuxième matériau isolant.

8. Procédé selon une des revendications 4 ou 7, **caractérisé en ce que** le remplissage partiel d'au moins une tranchée par un matériau conducteur comporte la réalisation d'au moins une région recouvrant la surface de la couche sacrificielle (4), pour former au moins un contact électrique entre un ou plusieurs piliers conducteurs.

9. Procédé selon l'une des revendications précédentes, **caractérisé en ce que** le remplissage est réalisé par la couche d'adhésion (50).

10. Procédé selon la revendication 1 et l'une des revendications 6 à 9, **caractérisé en ce que** le deuxième substrat (6) comporte au moins un circuit électronique, notamment CMOS, et **en ce que** la couche d'adhésion présente des plots localisés aptes à réaliser des contacts électriques entre le circuit électronique et lesdites régions de prise de contact.

11. Procédé selon une des revendications précédentes, **caractérisé en ce qu'**il comporte avant b, un dopage d'au moins une région localisée de la couche mécanique (3) pour permettre la réalisation d'un capteur piézorésistif.

12. Procédé selon une des revendications précédentes, **caractérisé en ce que** la couche d'arrêt (2) est en SiGe.

13. Procédé selon une des revendications précédentes, **caractérisé en ce que** la couche d'arrêt (2) est en Si poreux.

14. Procédé selon une des revendications précédentes, **caractérisé en ce que** la couche d'arrêt (2) est en Si dopé.

## Claims

1. A method of fabricating an electromechanical device including an active element, the method being **characterized in that** it comprises:
a) making a monocrystalline first stop layer (2) on a monocrystalline layer (1') of a first substrate (1);
b) growing a monocrystalline mechanical layer (3) epitaxially on said first stop layer (2) out of at least one material that is different from that of the stop layer (2);
c) making a sacrificial layer (4) on said active layer (3) out of a material that is suitable for being etched selectively relative to said mechanical layer (3);
d) making a bonding layer (50) on the sacrificial layer (4);
e) bonding a second substrate (6) on the bonding layer (50); and
f) eliminating the first substrate (1) and the stop layer (2) to reveal the surface (3₁) of the mechanical layer (3) opposite from the sacrificial layer (4), the active element being made by at least a portion of the mechanical layer (3).

2. A method according to claim 1, **characterized in that**, prior to depositing the bonding layer (50), it includes depositing a second stop layer.

3. A method according to any preceding claim, **characterized in that**, after step c), it implements the following steps:
c₁) making at least one trench (41, 42, 43) in the sacrificial layer (4); and
c₂) filling the trench(es) to form at least one pillar, the pillar being made at least in part out of a material that is different from the material of the sacrificial layer (4).

4. A method according to claim 3, **characterized in that** step c₂) comprises:
c₂₁) for at least one trench (41, 42), partial filling with a first material that is different from the material of the sacrificial layer (4); and
c₂₂) finishing off the filling with an insulating second material that is different from the first material.

5. A method according to claim 4, **characterized in that** the first material is an insulating material.

6. A method according to claim 4, **characterized in that** the first material is a conductive material.

7. A method according to claim 4, **characterized in that** for at least one trench (43), it presents partial filling with a first insulating material that is different from the material of the sacrificial layer (4) and of the mechanical layer (3), and then partial filling of the other trenches with a conductive material, the filling of all of the trenches being terminated by a second insulating material.

8. A method according to claim 4 or claim 7, **characterized in that** the partial filling of at least one trench by a conductive material includes making at least one region covering the surface of the sacrificial layer (4), to form at least one electrical contact between one or more conductive pillars.

9. A method according to any preceding claim, **characterized in that** the filling is performed with the bonding layer (50).

10. A method according to claim 1 and any one of claims 6 to 9, **characterized in that** the second substrate (6) includes at least one electronic circuit, in particular a CMOS circuit, and **in that** the bonding layer presents localized areas suitable for constituting electrical contacts between the electronic circuit and said contact-making regions.

11. A method according to any preceding claim, **characterized in that**, prior to step b), it includes doping at least one localized region of the mechanical layer (3) to enable a piezoresistive sensor to be made.

12. A method according to any preceding claim, **characterized in that** the stop layer (2) is made of SiGe.

13. A method according to any preceding claim, **characterized in that** the stop layer (2) is made of porous Si.

14. A method according to any preceding claim, **characterized in that** the stop layer (2) is made of doped Si.

## Patentansprüche

1. Verfahren zur Herstellung einer elektromechanischen Vorrichtung, welche ein aktives Element umfasst, **dadurch gekennzeichnet, dass** es umfasst:
a) Realisierung einer ersten monokristallinen Stoppschicht (2) auf einer monokristallinen Schicht (1') eines ersten Substrats (1),
b) Epitaxie, auf der ersten Stoppschicht (2), einer mechanischen monokristallinen Schicht (3) aus wenigstens einem Material, welches unterschiedlich zu demjenigen der Stoppschicht (2) ist,
c) Realisierung, auf der aktiven Schicht (3), einer Opferschicht (4) aus einem Material, welches dazu ausgestaltet ist, bezüglich der mechanischen Schicht (3) selektiv geätzt zu werden,
d) Realisierung einer Haftschicht (50) auf der Opferschicht (4),
e) Anhaften eines zweiten Substrats (6) auf der Haftschicht (50),
f) Eliminierung des ersten Substrats (1) und der Stoppschicht (2), um die Oberfläche (3₁) der mechanischen Schicht (3) gegenüber der Opferschicht (4) freizulegen, wobei das aktive Element durch wenigstens einen Teil der mechanischen Schicht (3) realisiert wird.

2. Verfahren nach Anspruch 1, **dadurch gekennzeichnet, dass** es vor der Deponierung der Haftschicht (50) die Deponierung einer zweiten Stoppschicht umfasst.

3. Verfahren nach einem der vorhergehenden Ansprüche, **dadurch gekennzeichnet, dass** es vor dem Schritt c) einsetzt:
c₁) Realisierung wenigstens eines Einschnitts (41, 42, 43) in der Opferschicht (4)
c₂) Auffüllen des oder der Einschnitte, um wenigstens eine Säule auszubilden, wobei diese Auffüllung wenigstens teilweise aus einem Material realisiert ist, welches sich von demjenigen der Opferschicht (4) unterscheidet.

4. Verfahren nach Anspruch 3, **dadurch gekennzeichnet, dass** c₂) umfasst:
c₂₁) für wenigstens einen Einschnitt (41, 42) teilweise Auffüllung durch ein erstes Material, welches sich von demjenigen der Opferschicht (4) unterscheidet und
c₂₂) Komplettierung der Auffüllung mit einem isolierenden zweiten Material, welches sich von dem ersten Material unterscheidet.

5. Verfahren nach Anspruch 4, **dadurch gekennzeichnet, dass** das erste Material isolierend ist.

6. Verfahren nach Anspruch 4, **dadurch gekennzeichnet, dass** das erste Material leitend ist.

7. Verfahren nach Anspruch 4, **dadurch gekennzeichnet, dass** es für wenigstens einen Einschnitt (43) ein teilweise Auffüllen durch ein isolierendes erstes Material, welches sich von dem Material der Opferschicht (4) und der mechanischen Schicht (3) unterscheidet, und darauf für die anderen Einschnitte durch ein leitendes Material aufweist, wobei die Auffüllung aller Einschnitte durch ein isolierendes zweites Material abgeschlossen wird.

8. Verfahren nach einem der Ansprüche 4 oder 7, **dadurch gekennzeichnet, dass** die teilweise Auffüllung wenigstens eines Einschnitts durch ein leitendes Material die Realisierung wenigstens eines Bereichs umfasst, welcher die Oberfläche der Opferschicht (4) bedeckt, um wenigstens einen elektrischen Kontakt zwischen einer oder mehreren leitenden Säulen auszubilden.

9. Verfahren nach einem der vorhergehenden Ansprüche, **dadurch gekennzeichnet, dass** die Auffüllung durch die Haftschicht (50) realisiert wird.

10. Verfahren nach Anspruch 1 und einem der Ansprüche 6-9, **dadurch gekennzeichnet, dass** das zweite Substrat (6) wenigstens eine elektronische Schaltung, insbesondere CMOS, umfasst, und dass die Haftschicht lokalisierte Kontakte aufweist, welche dazu ausgestaltet sind, elektrische Kontakte zwischen der elektronischen Schaltung und den Bereichen zur Kontaktherstellung zu realisieren.

11. Verfahren nach einem der vorhergehenden Ansprüche, **dadurch gekennzeichnet, dass** es vor b) ein Dotieren wenigstens eines lokalisierten Bereichs der mechanischen Schicht (3) umfasst, um die Realisierung eines piezoresistiven Sensors zu ermöglichen.

12. Verfahren nach einem der vorhergehenden Ansprüche, **dadurch gekennzeichnet, dass** die Stoppschicht (2) aus SiGe ist.

13. Verfahren nach einem der vorhergehenden Ansprüche, **dadurch gekennzeichnet, dass** die Stoppschicht (2) aus porösem Silizium ist.

14. Verfahren nach einem der vorhergehenden Ansprüche, **dadurch gekennzeichnet, dass** die Stoppschicht (2) aus dotiertem Silizium ist.
